# FASCICULE DE BREVET EUROPEEN

(11) **EP 1 434 237 B1**
(45) Date de publication et mention de la délivrance du brevet: **27.07.2005**
(21) Numéro de dépôt: 03293055.4
(22) Date de dépôt: 08.12.2003
(51) Int. Cl.: G11C 17/14, G11C 14/00

(54) **Cellule de mémoire SRAM non volatile**
Nichtflüchtige SRAM Speicherzelle
Non-volatile SRAM memory cell

(30) Priorité: 23.12.2002 FR 0216558
(43) Date de publication de la demande: 30.06.2004
(73) Titulaire: STMicroelectronics S.A., 92120 Montrouge (FR)
(72) Inventeur: Fournel, Richard, 38660 Lumbin (FR); Vincent, Emmanuel, 38100 Grenoble (FR); Bruyere, Sylvie, 38100 Grenoble (FR); Candelier, Philippe, 38190 Saint Mury (FR); Jacquet, Francois, 38190 Froges (FR)
(74) Mandataire: Dossmann, Gérard

(56) Documents cités:
- US-A- 4 207 615
- US-A- 5 757 696
- US-B1- 6 331 947

## Description

L'invention concerne les mémoires statiques à accès aléatoire (SRAM) réalisées en technologie MOS.

Comme on le sait, une cellule de mémoire SRAM conventionnelle comporte six transistors MOS agencés de manière à former des premier et deuxième inverseurs interconnectés entre des premier et deuxième noeuds de données.

Chaque inverseur comporte un transistor PMOS connecté en série avec un transistor NMOS entre une source d'alimentation en tension continue et un circuit de mise à la masse. Les grilles des transistors PMOS et NMOS de chaque inverseur sont reliées. Les électrodes communes entre les transistors NMOS et PMOS constituent un noeud de données.

Deux transistors NMOS assurent l'interconnexion de la cellule avec une ligne de mots et une ligne de bits, et permettent ainsi une lecture du point mémoire ou une modification de ce dernier.

De telles cellules sont avantageuses dans la mesure où elles sont relativement rapides. En effet, le temps de cycle, c'est-à-dire le temps minimal entre deux opérations successives de la mémoire, que ce soit en lecture ou en écriture, correspond au temps d'accès à la mémoire, c'est-à-dire le temps entre le moment où l'adresse est présente et le moment où la donnée lue est disponible à la sortie de la mémoire.

Cependant, avec ce type de mémoire, la mémoire est permanente tant que les circuits sont alimentés. En d'autres termes, les données sont perdues lorsque la mémoire n'est plus alimentée.

Il est donc nécessaire de coupler ces mémoires à des mémoires additionnelles non volatiles vers lesquelles les données sont transférées avant la coupure de l'alimentation.

US4207615 concern la programmation des cellule SRAM nonvolatile qui ont les premiers transistor inbalancés. Cette inbalance est obtenu pendent la fabrication.

Au vu de ce qui précède, le but de l'invention est de fournir une cellule de mémoire SRAM, non volatile, c'est-à-dire capable de conserver son contenu de manière permanente.

Ainsi, selon l'invention, il est proposé une cellule de mémoire SRAM comprenant des premier et deuxième inverseurs interconnectés entre des premier et deuxième noeuds de données, chaque inverseur comportant des transistors MOS complémentaires connectés en série entre une source d'alimentation en tension continue et un circuit de mise à la masse.

Cette cellule comporte, selon une caractéristique générale, des moyens de programmation des transistors MOS adaptés pour provoquer, après programmation, une dégradation irréversible d'une couche d'oxyde de grille d'une partie au moins des transistors.

Il a ainsi été constaté qu'une telle dégradation engendre une modification des caractéristiques des transistors, entraînant une chute du courant de drain pouvant aller jusqu'à environ 30 %. Une telle dégradation est alors utilisée pour le stockage d'informations, pendant une durée de rétention pouvant aller jusqu'à une dizaine d'années.

Selon une autre caractéristique de cette cellule, chaque inverseur comporte un premier transistor PMOS et un deuxième transistor NMOS couplés en série entre la source d'alimentation et le circuit de mise à la masse, les noeuds des données étant respectivement formés entre les deux transistors NMOS et PMOS des inverseurs.

Selon encore une autre caractéristique de la cellule mémoire SRAM selon l'invention, le transistor MOS dégradé est un transistor à couche d'oxyde de grille mince, également connu sous l'appellation transistor GO1.

Après programmation, la couche d'oxyde est dégradée au moins localement de manière à obtenir, lors de la lecture de la cellule, une variation du courant délivré par le transistor

Selon un mode de réalisation, les moyens de programmation comportent, pour chaque inverseur, un transistor de programmation raccordé entre une ligne de commande de programmation et les transistors de l'inverseur.

Ces moyens de programmation comportent ainsi, par exemple, un transistor NMOS assurant le raccordement sélectif de la grille d'un transistor à dégrader à une source de tension de programmation délivrant un niveau de tension apte à provoquer, conjointement avec la source d'alimentation en tension continue qui est raccordée au drain dudit transistor, une dégradation de la couche d'oxyde de grille du transistor, le transistor de programmation étant piloté par la ligne de commande de programmation.

En outre, selon une autre caractéristique, cette cellule comporte des moyens pour provoquer le fonctionnement de la cellule en tant que mémoire SRAM après programmation.

Ces moyens peuvent être réalisés sous la forme de transistors NMOS assurant l'interconnexion des inverseurs, ces transistors étant raccordés à une ligne de commande du fonctionnement de la cellule en tant que mémoire SRAM.

Les électrodes de drain et de source de chacun de ces transistors NMOS sont respectivement raccordées à la grille des transistors de l'un des inverseurs.

D'autres buts, caractéristiques et avantages de l'invention apparaîtront à la lecture de la description qui va suivre, donnée uniquement à titre d'exemple non limitatif, et faite en référence aux dessins annexés, sur lesquels :
- la figure 1 est un schéma illustrant la structure d'une cellule de mémoire SRAM statique, non volatile, conforme à l'invention ; et
- la figure 2 montre l'évolution de signaux de commande appliqués à la cellule de la figure 1.

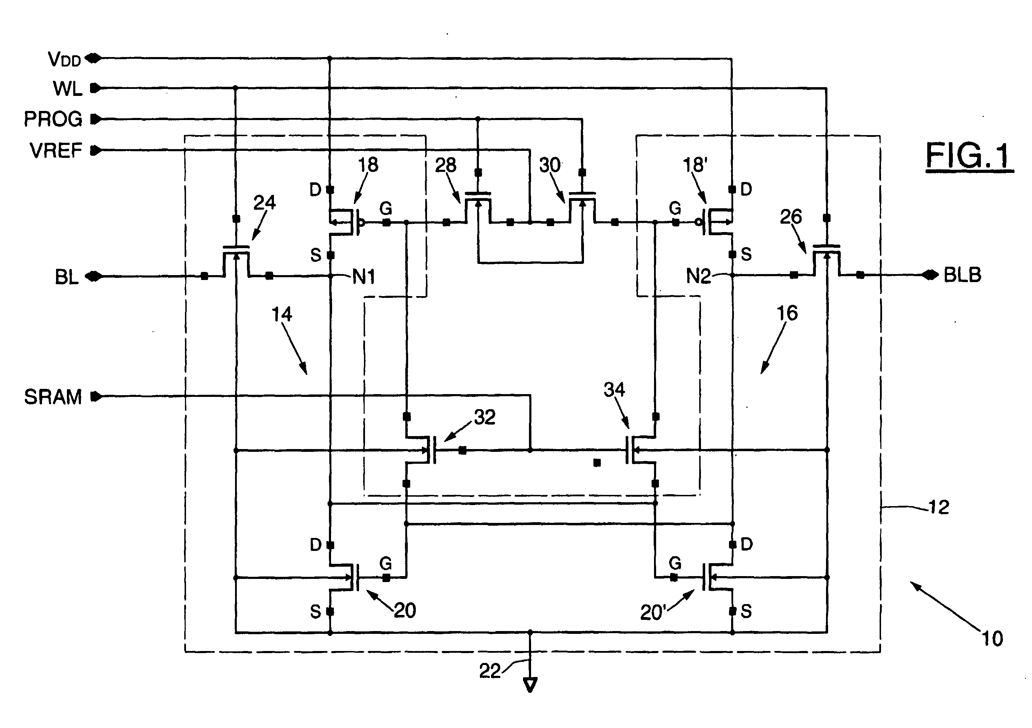

Sur la figure 1, on a représenté la structure générale d'une cellule SRAM non volatile, conforme à l'invention, désignée par la référence numérique générale 10.

Comme on le voit sur cette figure, cette cellule de mémoire SRAM 10 est réalisée à partir d'une structure de point mémoire 12 SRAM ayant un comportement conventionnel, complétée de manière à permettre de provoquer une dégradation de transistors entrant dans la constitution du point mémoire 12 lors de la programmation de la cellule 10, de manière à provoquer une dégradation irréversible de ces transistors telle qu'elle provoque une diminution du courant délivré par ces transistors lors de la lecture et diminution de la tension de seuil.

Comme on le voit sur cette figure 1, le point mémoire SRAM 12 est constitué par une association de deux inverseurs 14 et 16 interconnectés.

Plus particulièrement, chaque inverseur 14 et 16 est constitué par l'association en série d'un premier transistor PMOS, respectivement 18 et 18' et d'un deuxième transistor NMOS, respectivement 20 et 20', raccordés en série entre une source d'alimentation en tension continue V_{DD} et un circuit de mise à la masse 22.

Les transistors sont agencés de sorte que le drain D de chacun des premiers transistors PMOS 18 et 18' soit raccordé à la source d'alimentation V_{DD} et que leurs sources soient raccordées au drain D des deuxièmes transistors NMOS 20 et 20' du même inverseur et à la grille G du deuxième transistor NMOS 20 de l'autre inverseur

Deux transistors additionnels 24 et 26, qui permettent l'accès aux noeuds de donnée N1 et N2 de la cellule de mémoire SRAM qui sont formés au niveau de l'interconnexion des premier et deuxième transistors 18, 18' et 20, 20' de chaque inverseur 14 et 16, sont commandés par une ligne de mots WL pour transférer un bit mémorisé vers des lignes de bits BL et BL B.

Pour la programmation de la cellule SRAM 10, celle-ci est pourvue de transistors de programmation 28 et 30, constitués par des transistors NMOS placés en série entre les grilles G des premiers transistors PMOS 18, 18' des inverseurs 14 et 16.

Ces transistors 28 et 30 sont commandés par une ligne de commande de programmation PROG, la grille de chacun de ces transistors étant connectée à cette ligne de commande PROG. Par ailleurs, les électrodes de drain et de source de ces transistors de commande sont respectivement raccordées à une deuxième source d'alimentation en tension continue V_{REF} destinée à positionner la grille des premiers transistors 18 à un niveau permettant une dégradation de l'oxyde de grille. De même, la tension V_{DD} fournie par la première source d'alimentation en tension continue est choisie de manière à créer une tension V_{DS} entre la source et le drain de ces transistors apte à provoquer une dégradation de la couche d'oxyde de grille de ces transistors.

Pour la réalisation des premiers transistors 18, 18' de chacun des inverseurs 14 et 16, on utilise un transistor MOS de type à oxyde de grille mince, également connu sous l'appellation « Transistor MOS GO1 ». Tous les autre transistors sont des transistors à oxyde épais pour ne pas être affecté par le stress de programmation.

Avec de tels transistors, par exemple, pour provoquer une dégradation de la couche d'oxyde de grille, on utilise une tension V_{DD} de l'ordre de 3,3 Volts et une tension V_{REF} de l'ordre de 2 Volts. Dans ces conditions, il est créé une dégradation locale de la couche d'oxyde de grille du côté de la zone de drain de ces transistors, laquelle engendre une chute de la tension de seuil de ces transistors ainsi qu'une chute du courant de drain. Une telle chute de courant peut atteindre une valeur de 30 %, en fonction des conditions de lecture. Par exemple, on atteint une réduction du courant de 22 % pour une tension de grille de 1,2 Volts et une tension de drain de 1,2 Volts. Une réduction du courant de 30 % est atteinte pour une tension de grille de 1,2 Volts et une tension de drain de 0,1 Volt.

On voit enfin, sur la figure 1, que les premier et deuxième transistors 18 et 20 de chaque inverseur sont interconnectés par l'intermédiaire de transistors NMOS additionnels 32 et 34 agencés de sorte que leur grille G soit raccordée à une ligne SRAM de commande du fonctionnement de la cellule en tant que mémoire SRAM et que leur drain et leur source soient respectivement connectés à la grille des premier et deuxième transistors 18 et 20. Ainsi, un niveau haut sur cette ligne de commande SRAM provoque le raccordement de la grille G des transistors des inverseurs 14 et 16.

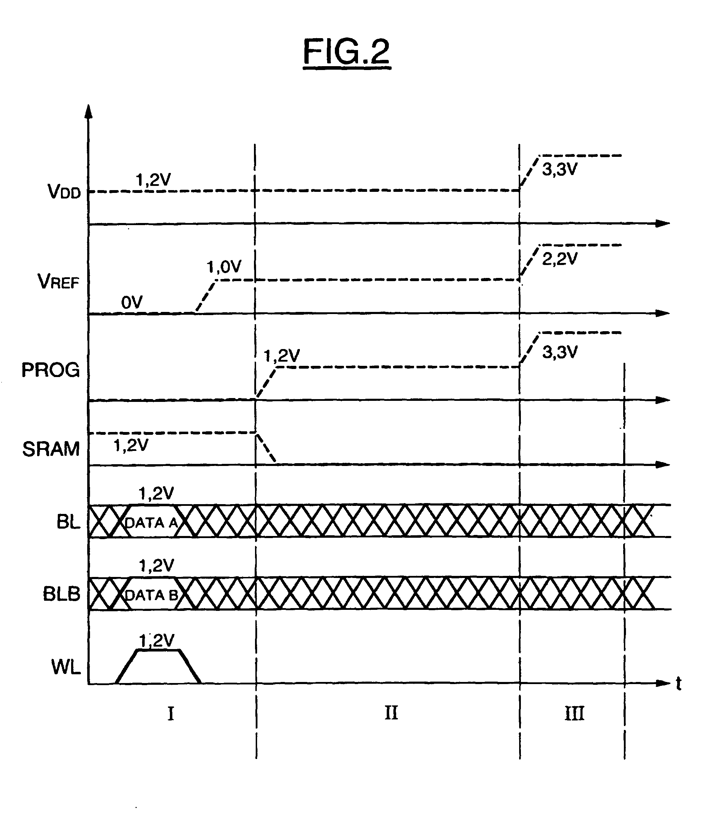

On va maintenant décrire, en référence à la figure 2, l'évolution des niveaux de tension disponibles sur les lignes V_{DD}, V_{REF}, PROG et SRAM

Comme indiqué précédemment, lors d'un cycle I de fonctionnement de la cellule 10 en tant que mémoire SRAM, la tension disponible sur la ligne SRAM est positionnée à un niveau haut, par exemple de l'ordre de 1,2 Volt. Les niveaux de tension sur les lignes V_{REF} et PROG sont positionnés à un niveau bas et la tension V_{DD} délivrée par la première source d'alimentation en tension est positionnée à un niveau bas, par exemple de 1,2 Volt.

Pour réaliser un cycle d'introduction d'une donnée à programmer, cette donnée « DATA » est positionnée sur les lignes de bits BL et BL B, c'est-à-dire (0-1) ou (1-0). Puis le ligne de mots WL passe à l'état haut de façon à positionner le point mémoire. La ligne de mots WL passe ensuite à l'état bas. Les lignes de bits BL et BL B peuvent ensuite changer d'état de façon à écrire les autres cellules positionnées sur les même lignes de bits.

Pour provoquer la programmation de la cellule, la tension sur la ligne SRAM est annulée et la tension fournie par les lignes PROG et V_{REF} est élevée jusqu'à un niveau de l'ordre de 1 Volt, par exemple 1,2 Volt pour la tension sur la ligne PROG et 1 Volt pour la ligne V_{REF} (cycle II). Enfin, pour procéder à la programmation proprement dite (cycle III), la tension sur la ligne PROG et la tension délivrée par la première source d'alimentation V_{DD} sont élevées à un niveau de 3,3 Volts. En ce qui concerne la tension V_{REF} délivrée par la deuxième source d'alimentation en tension, celle-ci est par exemple réglée à un niveau de 2,2 Volts.

De tels niveaux de tension engendrent, comme indiqué précédemment, une dégradation irréversible des transistors 18 et 18', laquelle peut être utilisée pour le stockage d'une information pendant une durée pouvant aller jusqu'à une dizaine d'années.

A la mise sous tension, les noeuds N1 et N2 sont à 0V. En fonction de la donnée préalablement programmée, l'un des transistors MOS 18 ou 18' fournit moins de courant que l'autre MOS 18' ou 18. Le noeud N2 s'initialise à 1 et N1 à 0V, ou N2 à 0V et N1 à 1, lors de la montée de l'alimentation. Lors de la lecture, la ligne de bits WL et le signal PROG sont à 0. Le signal SRAM doit être à 1 avant la montée de V_{DD}. Enfin, la donnée est positionnée sur le lignes de bits BL et BLB.

On notera enfin que les transistors 28 et 30 des moyens de programmation peuvent être remplacées par des diodes ou des transistors montés en diode.

## Revendications

1. Cellule de mémoire SRAM comprenant des premier et deuxième inverseurs (14, 16) interconnectés entre des premier et deuxième noeuds (N1, N2) de données, chaque inverseur comportant des transistors MOS complémentaires (18, 20, 18', 20') connectés en série entre une source d'alimentation en tension continue (V_{DD}) et un circuit de mise à la masse (22), **caractérisée en ce qu'**elle comporte en outre des moyens de programmation (28, 30) des transistors MOS adaptés pour provoquer, après programmation, une dégradation irréversible d'une couche d'oxyde de grille d'une partie au moins des transistors.

2. Cellule de mémoire SRAM selon la revendication 1, **caractérisée en ce que** chaque inverseur comporte un premier transistor PMOS (18, 18') et un deuxième transistor NMOS (20, 20') couplés en série entre la source d'alimentation et le circuit de mise à la masse, les noeuds de données (N1, N2) étant respectivement formés entre les deux transistors NMOS et PMOS des inverseurs.

3. Cellule de mémoire SRAM selon l'une des revendications 1 et 2, **caractérisée en ce que** le transistor MOS dégradé est un transistor à couche d'oxyde de grille mince (GO1).

4. Cellule de mémoire SRAM selon l'une quelconque des revendications 1 à 3, **caractérisée en ce que** la couche d'oxyde est dégradée au moins localement de manière à obtenir, lors de la lecture de la cellule, une variation du courant délivré par le transistor.

5. Cellule de mémoire SRAM selon l'une quelconque des revendications 2 à 4, **caractérisée en ce que** les moyens de programmation comportent, pour chaque inverseur, un transistor de programmation (28, 30) ou une diode raccordée entre une ligne de commande de programmation (PROG) et l'un des transistors de l'inverseur.

6. Cellule de mémoire SRAM selon la revendication 5, **caractérisée en ce que** les moyens de programmation comportent un transistor NMOS ou une diode de programmation (28, 30) assurant le raccordement sélectif de la grille d'un transistor (18) à dégrader à une source de tension de programmation (VREF) délivrant un niveau de tension apte à provoquer, conjointement avec la source d'alimentation en tension continue raccordée au drain dudit transistor (18), une dégradation de la couche d'oxyde de grille du transistor, le transistor de programmation étant piloté par la ligne de commande de programmation (PROG).

7. Cellule de mémoire SRAM selon l'une quelconque des revendications 1 à 6, **caractérisée en ce qu'**elle comporte en outre des moyens (32, 34) pour provoquer le fonctionnement de la cellule en tant que mémoire SRAM après programmation.

8. Cellule de mémoire SRAM selon la revendication 7, **caractérisée en ce que** les inverseurs sont interconnectés par l'intermédiaire de transistors NMOS (32, 34) raccordés à une ligne (SRAM) de commande du fonctionnement de la cellule en tant que mémoire SRAM.

9. Cellule de mémoire SRAM selon la revendication 8, **caractérisée en ce que** les électrodes de drain et de source de chacun desdits transistor NMOS (32, 34) sont respectivement raccordées à la grille des transistors de l'un des inverseurs.

## Patentansprüche

1. SRAM-Speicherzelle mit einem ersten und zweiten Inverter (14,16), die zwischen einem ersten und zweiten Datenknoten (N1,N2) miteinander verbunden sind, wobei jeder Inverter komplementäre MOS-Transistoren (18,20,18',20') aufweist, die in Serie zwischen einer Gleichspannungsversorgungsquelle (V_{DD}) und einer Erdungsschaltung (22) angeordnet sind, **dadurch gekennzeichnet, daß** die Speicherzelle ferner Einrichtungen zum Programmieren (28,30) der MOS-Transistoren aufweist, die geeignet sind, um eine irreversible Degradation der Gateoxidschicht zumindest eines Teils der Transistoren hervorzurufen.

2. SRAM-Speicherzelle nach Anspruch 1, **dadurch gekennzeichnet, daß** jeder Inverter einen ersten PMOS-Transistor (18,18') und einen zweiten NMOS-Transistor (20,20') aufweist, die in Serie zwischen der Versorgungsquelle und der Erdungsschaltung angeordnet sind, wobei die Datenknoten (N1,N2) jeweils zwischen den NMOS- und PMOS-Transistoren der Inverter gebildet sind.

3. SRAM-Speicherzelle nach einem der Ansprüche 1 und 2, **dadurch gekennzeichnet, daß** der degradierte MOS-Transistor ein Transistor mit dünner Gateoxidschicht (GO1) ist.

4. SRAM-Speicherzelle nach einem der Ansprüche 1 bis 3, **dadurch gekennzeichnet, daß** die Oxidschicht zumindest lokal degradiert ist, so daß beim Lesen der Zelle eine Änderung des von dem Transistor ausgegebenen Stroms erzielt wird.

5. SRAM-Speicherzelle nach einem der Ansprüche 2 bis 4, **dadurch gekennzeichnet, daß** für jeden Inverter die Programmierungseinrichtungen einen Programmierungstransistor (28,30) oder eine Diode aufweisen, der bzw. die zwischen einer Programmierungssteuerleitung (PROG) und einem der Transistoren des Inverters angeordnet ist.

6. SRAM-Speicherzelle nach Anspruch 5, **dadurch gekennzeichnet, daß** die Programmierungseinrichtungen einen NMOS-Transistor oder eine Programmierungsdiode (28,30) aufweisen, der bzw. die die selektive Verbindung der Gate-Elektrode eines zu degradierenden Transistors (18) mit einer Programmierungsspannungsquelle (VREF) sicherstellt, die einen Spannungspegel bereitstellt, der geeignet ist, um gemeinsam mit der Gleichspannungsversorgungsquelle, die mit der Drain-Elektrode des Transistors (18) verbunden ist, eine Degradation der Gateoxidschicht des Transistors hervorzurufen, wobei der Programmierungstransistor von der Programmierungssteuerleitung (PROG) gesteuert wird.

7. SRAM-Speicherzelle nach einem der Ansprüche 1 bis 6, **dadurch gekennzeichnet, daß** sie ferner Einrichtungen (32,34) aufweist, um nach der Programmierung den Betrieb der Zelle als SRAM-Speicher zu bewirken.

8. SRAM-Speicherzelle nach Anspruch 7, **dadurch gekennzeichnet, daß** die Inverter über NMOS-Transistoren (32,34), die an einer Leitung (SRAM) zur Steuerung des Betriebs der Zelle als SRAM-Speicher angeschlossen sind, miteinander verbunden sind.

9. SRAM-Speicherzelle nach Anspruch 8, **dadurch gekennzeichnet, daß** die Drain- und die Source-Elektrode jedes der NMOS-Transistoren (32,34) jeweils mit der Gate-Elektrode der Transistoren eines der Inverter verbunden sind.

## Claims

1. SRAM memory cell comprising first and second inverters (14, 16) interconnected between first and second data nodes (N1, N2), each inverter comprising complementary MOS transistors (18, 20, 18', 20') connected in series between a DC voltage supply source (V_{DD}) and an earthing circuit (22), **characterized in that** it furthermore comprises means (28, 30) for programming the MOS transistors adapted for causing, after programming, an irreversible degradation of a gate oxide layer of some at least of the transistors.

2. SRAM memory cell according to Claim 1, **characterized in that** each inverter comprises a first PMOS transistor (18, 18') and a second NMOS transistor (20, 20') coupled in series between the supply source and the earthing circuit, the data nodes (N1, N2) being formed respectively between the two NMOS and PMOS transistors of the inverters.

3. SRAM memory cell according to either of Claims 1 and 2, **characterized in that** the degraded MOS transistor is a thin gate oxide layer transistor (GO1).

4. SRAM memory cell according to any one of Claims 1 to 3, **characterized in that** the oxide layer is degraded at least locally in such a way as to obtain, during the reading of the cell, a variation in the current delivered by the transistor.

5. SRAM memory cell according to any one of Claims 2 to 4, **characterized in that** the programming means comprise, for each inverter, a programming transistor (28, 30) or a diode linked between a programming control line (PROG) and one of the transistors of the inverter.

6. SRAM memory cell according to Claim 5, **characterized in that** the programming means comprise an NMOS transistor or a programming diode (28, 30) ensuring the selective linking of the gate of a transistor (18) to be degraded to a programming voltage source (VREF) delivering a voltage level able to cause, jointly with the DC voltage supply source linked to the drain of the said transistor (18), a degradation in the gate oxide layer of the transistor, the programming transistor being driven by the programming control line (PROG).

7. SRAM memory cell according to any one of Claims 1 to 6, **characterized in that** it furthermore comprises means (32, 34) for causing the cell to operate as an SRAM memory after programming.

8. SRAM memory cell according to Claim 7, **characterized in that** the inverters are interconnected by way of NMOS transistors (32, 34) linked to a control line (SRAM) for instructing the cell to operate as an SRAM memory.

9. SRAM memory cell according to Claim 8, **characterized in that** the drain electrode and source electrode of each of the said NMOS transistors (32, 34) are respectively linked to the gate of the transistors of one of the inverters.
